# EUROPEAN PATENT APPLICATION

(11) **EP 3 091 569 A1**
(43) Date of publication of application: **09.11.2016**
(21) Application number: 16156420.8
(22) Date of filing: 19.02.2016
(51) Int. Cl.: H01L 23/482, H01L 23/49, H01L 25/065

(54) **BONDING PAD ARRANGEMENT DESIGN FOR SEMICONDUCTOR PACKAGE**

(30) Priority: 16.04.2015 US 201562148330 P; 26.01.2016 US 201615006386
(71) Applicant: MediaTek, Inc, Hsin-Chu 300 (TW)
(72) Inventor: CHEN, Ying-Chih, 815 Kaohsiung City (TW); CHOU, Che-Ya, 806 Kaohsiung City (TW); LIN, Min-Yu, 302 Hsinchu County (TW); YANG, Chia-Hao, 302 Hsinchu County (TW); CHU, Wen-Pin, 302 Hsinchu County (TW)
(74) Representative: Goddar, Heinz J.

(57) **Abstract**

A semiconductor memory package is provided. The package includes a semiconductor die having a first die portion (100a) and a second die portion (100c). A -passivation layer (102) is on the semiconductor die (100). A first post-passivation interconnect (PPI) structure includes pluralities of first and second pads (104,106) arranged in first and second tiers (201, 202), respectively. The first and second pads (104, 106) are disposed on a first die (100a) portion of the semiconductor die (100). A second PPI structure includes pluralities of third and fourth pads (108,110) arranged in third and fourth tiers (203, 204), respectively. The third and fourth pads (108,110) are disposed on a second die portion (100b) of the semiconductor die (100). One of the first pads (104) and one of the fourth pads (110) are coupled to each other by a first bonding wire (120). One of the second pads (106) and one of the third pads (110) are coupled to each other by a second bond wire (130).

## Description

### BACKGROUND

### Field of the Disclosure

The disclosure relates to a semiconductor package structure, and in particular to a die-to-die wire bonding pad arrangement design for a semiconductor package.

### Description of the Related Art

In recent years, the demand for high-capacity semiconductor memories has been rapidly increasing in response to the high performance and multi-functionality of electronic appliances. Generally, several methods for increasing storage capacity of semiconductor memories have been widely used. For example, one method for increasing storage capacity of semiconductor memories is to increase the degree of integration of semiconductor dies. Although the method of increasing the integration degree of semiconductor dies is able to easily increase storage capacity of semiconductor memories, fabrication costs and time consumed in development and research environments are greatly increased.

Another method for increasing storage capacity of semiconductor memories is to arrange a plurality of semiconductor memory dies into a single semiconductor package (i.e., multi-die semiconductor package). For example, semiconductor memory dies are horizontally or vertically populating a single semiconductor package. However, this method unavoidably increases fabrication costs because the design of a package substrate needs to change in response to such an arrangement of semiconductor memory dies. Moreover, the package size may also be increased due to such a change of the design of the package substrate. Accordingly, the current multi-die semiconductor package cannot adjust to the miniaturization of electronic appliances.

Thus, a novel semiconductor memory package with high capacity is desirable.

### SUMMARY

A semiconductor package is provided. An exemplary embodiment of a semiconductor package includes a semiconductor die having a first die portion, a second die portion, and a scribe line portion between the first and second die portions. A post-passivation layer is on the semiconductor die and has a first region and a second region adjacent thereto. A first post-passivation interconnect structure includes a plurality of first pads arranged in a first tier and a plurality of second pads arranged in a second tier. The first and second pads are disposed on the first region of the post-passivation layer corresponding to the first die portion. A second post-passivation interconnect structure includes a plurality of third pads arranged in a third tier and a plurality of fourth pads arranged in a fourth tier. The third and fourth pads are disposed on the first region of the post-passivation layer corresponding to the second die portion. A first bonding wire has two terminals respectively coupled to one of the first pads and one of the fourth pads. A second bonding wire has two terminals respectively coupled to one of the second pads and one of the third pads.

A detailed description is given in the following embodiments with reference to the accompanying drawings.

### BRIEF DESCRIPTION OF DRAWINGS

The disclosure can be more fully understood by reading the subsequent detailed description and examples with references made to the accompanying drawings, wherein:
FIG. 1A is a top view of an exemplary embodiment of a semiconductor device, explicitly showing one exemplary embodiment of a die-to-die wire bonding pad arrangement design for a semiconductor device.
FIG. 1B is a side perspective view of an exemplary embodiment of a semiconductor device as shown in FIG. 1A.
FIG. 2A is a top view showing an exemplary embodiment of a semiconductor package having a semiconductor device as shown in FIG. 1A.
FIG. 2B is a side perspective view of an exemplary embodiment of a semiconductor package as shown in FIG. 2A.
FIG. 3 is a side perspective view of an exemplary embodiment of a semiconductor package.

### DETAILED DESCRIPTION

The following description encompasses the fabrication process and the purpose of the disclosure. It should be understood that this description is provided for the purpose of illustrating the fabrication process and the use of the disclosure and should not be taken in a limiting sense. In the drawings or disclosure, the same or similar elements are represented or labeled with the same or similar symbols. Moreover, the shapes or thicknesses of the elements shown in the drawings may be magnified for simplicity and convenience. Additionally, common elements which are well known in the art are not shown or described in the drawings or disclosure.

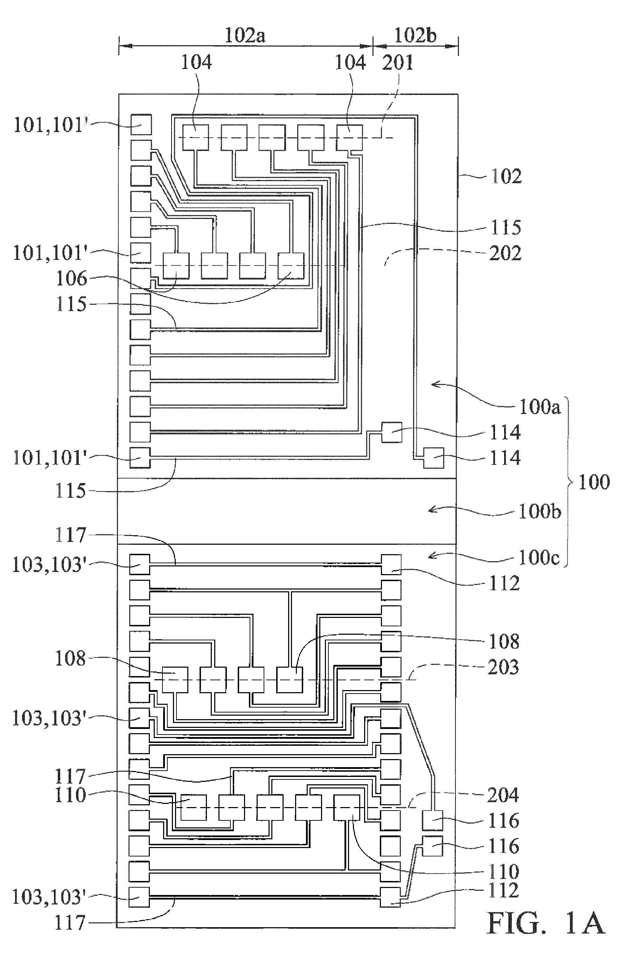

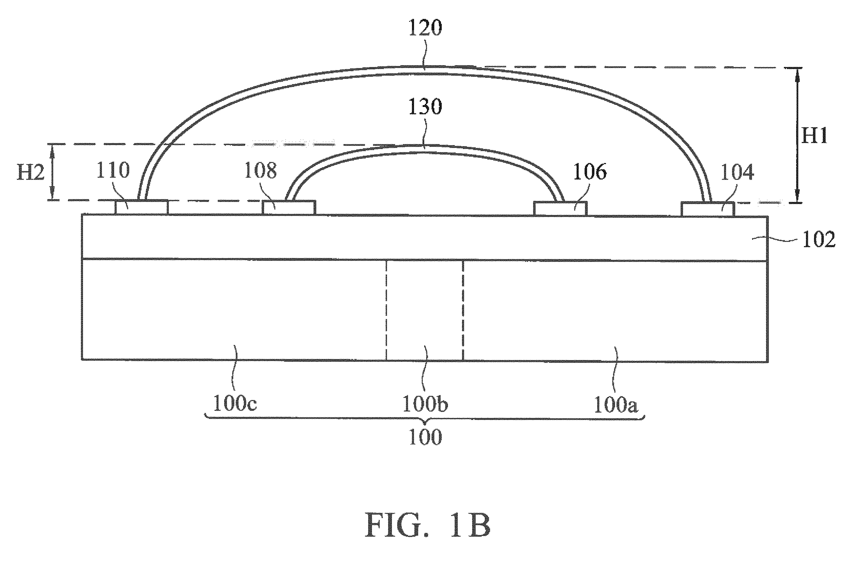

Referring to FIGS. 1A and 1B, FIG. 1A is a top view of an exemplary embodiment of a semiconductor device, explicitly showing one exemplary embodiment of a die-to-die wire bonding pad arrangement design for a semiconductor device. FIG. 1B is an exemplary embodiment of a semiconductor device as shown in FIG. 1A. In the embodiment, the semiconductor device includes a semiconductor die 100, such as a random access memory (RAM) die. As shown in FIG. 1A, the semiconductor die 100 includes a first die portion 100a, a second die portion 100c and a scribe line portion 100b between the first die portion 100a and the second die portion 100c.

In one embodiment, the semiconductor die 100 can be obtained by dividing a wafer having a plurality of memory die regions into individual dies. For example, an existing known good die (KGD) wafer having a plurality of memory die regions defined by a plurality of scribe lines is provided. The KGD wafer is then divided into individual dies, in which some of the individual dies include two adjacent memory die regions that are separated by a scribe line. Namely, an individual die that includes a scribe line and two die regions defines the scribe portion 100b, the first die portion 100a and the second die portion 100c of the semiconductor die 100.

In the embodiment, the semiconductor device further includes a passivation layer 102 covering a top surface of the semiconductor die 100, as shown in FIG. 1B. The passivation layer 102 may be formed of non-organic materials such as silicon oxide, silicon nitride, silicon oxynitride, undoped silicate glass (USG) and the like. In the embodiment, the passivation layer 102 has a first region 102a and a second region 102b adjacent thereto, as shown in FIG. 1A. Moreover, the passivation layer 102 includes openings (not shown) therein corresponding to the first region 102a to expose contact pads (i.e., input/output (I/O) pads) 101' of the first die portion 100a and contact pads (i.e., I/O pads) 103' of the second die portion 100c. Typically, these I/O pads include signal pads, power pads and ground pads.

In the embodiment, the semiconductor device further includes a first post-passivation interconnect (PPI, so named because it is formed after formation of a passivation layer) structure and a second PPI structure on the passivation layer 102. The first and second PPI structures correspond to the first die portion 100a and the second portion 100c of the semiconductor die 100, respectively. In one embodiment, the first PPI structure includes a plurality of PPI pads 101, a plurality of power/ground pads 114, a plurality of first pads 104, a plurality of second pads 106 and a plurality of redistribution lines 115 for connecting these pads 101, 104, 106 and 114. The PPI pads 101 are disposed on the first region 102a of the passivation layer 102 and aligned to the contact pads 101' of the first die portion 100a. The PPI pads 101 are arranged in a line that is close to and parallel to an edge of the first die portion 100a, and are correspondingly and electrically connected to the contact pads 101' of the first die portion 100a through the passivation layer 102. The power/ground pads 114 are disposed on the second region 102b of the passivation layer 102. Moreover, the power/ground pads 114 are electrically connected to some of the PPI pads 101 that are coupled to power/ground pads (i.e., contact pads) of the first die portion 100a through the redistribution lines 115.

The first pads 104 and the second pads 106 are disposed on the first region 102a of the passivation layer 102 and arranged in a first tier 201 and a second tier 202, respectively. In one embodiment, the first tier 201 and the second tier 202 are parallel to each other, and no pad is between the first tier 201 and the second tier 202. Moreover, the first tier 201 and the tier 202 are parallel to an extending direction of the scribe line portion 100b. In one embodiment, the first tier 201 is parallel to an edge of the first die portion 100a parallel to the extending direction of the scribe line portion 100b, such that the first tier 201 is closer to the edge the first die portion 100a than the second tier 202 is, and the second tier 202 is closer to the scribe line portion 100b than the first tier 201 is. Moreover, the first pads 104 and the second pads 106 are electrically connected to some of the PPI pads 101 that are coupled to signal pads (i.e., contact pads) of the first die portion 100a through the redistribution lines 115. In the embodiment, some of the first pads 104 may correspond to some of the second pads 106. Moreover, some of the first pads 104 may be aligned or non-aligned to the corresponding second pads 106. In the embodiment, the total number of first pads 104 is equal to or different from the total number of second pads 106. For example, the total number of first pads 104 is greater than the total number of second pads 106. Note that the number of pads 101, 104, 106 and 114 shown in FIG. 1A is exemplary, and the invention is not limited thereto.

In one embodiment, the second PPI structure includes a plurality of PPI pads 103, a plurality of power/ground pads 116, a plurality of third pads 108, a plurality of fourth pads 110, a plurality of fifth pads 112 and a plurality of redistribution lines 117 for connecting these pads 103, 108, 110, 112 and 114. The PPI pads 103 are disposed on the first region 102a of the passivation layer 102 and aligned to the contact pads 103' of the second die portion 100c. The PPI pads 103 are arranged in a line that is close to and parallel to an edge of the second die portion 100c, and are correspondingly and electrically connected to the contact pads 103' of the second die portion 100c through the passivation layer 102. The power/ground pads 116 are disposed on the second region 102b of the passivation layer 102. Moreover, the power/ground pads 116 are electrically connected to some of the PPI pads 101 that are coupled to power/ground pads (i.e., contact pads) of the second die portion 100c through the redistribution lines 117.

The third pads 108 and the fourth pads 110 are disposed on the first region 102a of the passivation layer 102 and arranged in a third tier 203 and a fourth tier 204, respectively. In one embodiment, the third tier 203 and the fourth tier 204 are parallel to the first tier 201 and the second tier 202, and no pad is between the third tier 203 and the fourth tier 204. Moreover, the third tier 203 and the fourth tier 204 are also parallel to the extending direction of the scribe line portion 100b. In one embodiment, the fourth tier 204 is parallel to an edge of the second die portion 100c parallel to the extending direction of the scribe line portion 100b, such that the fourth tier 204 is closer to the edge the second die portion 100c than the third tier 203 is, and the third tier 203 is closer to the scribe line portion 100b than the fourth tier 204 is. Moreover, the third pads 108 and the fourth pads 110 are electrically connected to some of the PPI pads 103 that are coupled to signal pads (i.e., contact pads) of the second die portion 100c through the redistribution lines 117. In the embodiment, some of the third pads 108 may correspond to some of the fourth pads 110. Moreover, some of the fourth pads 110 may be aligned or non-aligned to the corresponding third pads 108. In the embodiment, the total number of fourth pads 110 is equal to or different from the total number of third pads 108. For example, the total number of fourth pads 110 is greater than the total number of third pads 108. In the embodiment, the total number of the first pads 104 is equal to the total number of the fourth pads 110, and the total number of the second pads 106 is equal to the total number of the third pads 108.

The fifth pads 112 are disposed on the second region 102b of the passivation layer 102. In one embodiment, the fifth pads 112 are arranged along a direction perpendicular to the first tier 201, second tier 202, third tier 203 and fourth tier 204. Moreover, the fifth pads 112 are electrically connected to some of the PPI pads 103 that are coupled to signal pads (i.e., contact pads) of the second die portion 100c through the redistribution lines 117. The fifth pads 112 are electrically connected to the third pads 108 and fourth pads 110 through the redistribution lines 117. Also, note that the number of pads 103, 108, 110, 112 and 116 shown in FIG. 1A is exemplary, and the invention is not limited thereto.

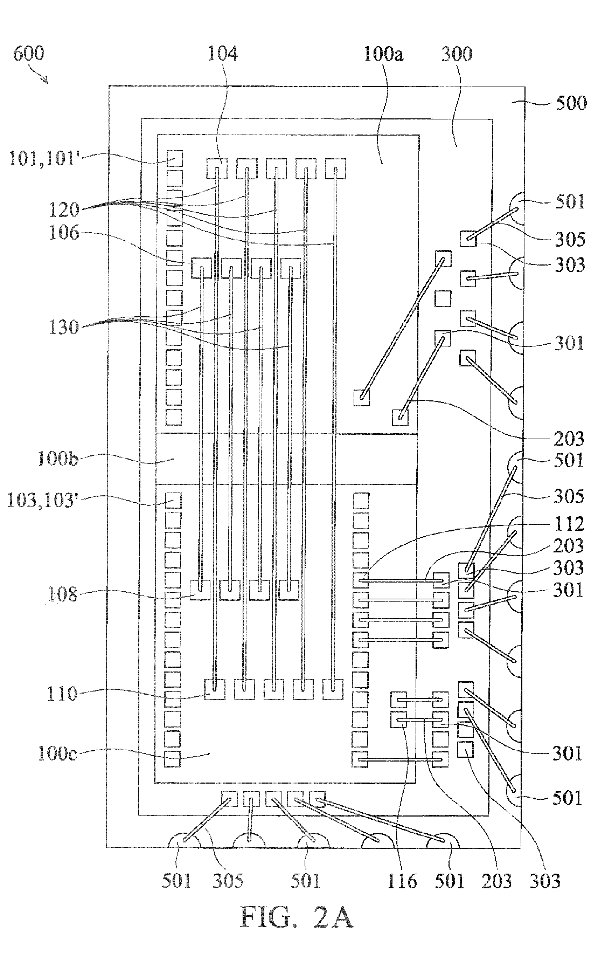

In the embodiment, the semiconductor device further includes a plurality of first bonding wires 120 and a plurality of second bonding wires 130 (which are not shown in FIG. 1A, but are shown in FIG. 2A). The first and second bonding wires 120 and 130 are used as die-to-die bonding wires for the first die portion 100a and the second die portion 100c of the semiconductor die 100. Herein, in order to simplify the diagram, only a first bonding wire 120 and a second bonding wire 130 are depicted in FIG. 1B. As shown in FIG. 1B, the first bonding wire 120 has two terminals respectively coupled to one of the first pads 104 and one of the fourth pads 110. Similarly, the second bonding wire 130 has two terminals respectively coupled to one of the second pads 106 and one of the third pads 108. In the embodiment, each first bonding wire 120 has a wire bonding height H1 and each second bonding wire 130 has a wire bonding height H2. Moreover, the wire bonding height H1 is greater than the wire bonding height H2 to avoid the short-circuit problem. After first and second bonding wires 120 and 130 are coupled between the first and fourth pads 104 and 110 and between the second and third pads 106 and 108, respectively, the contact pad 101' of the first die portion 100a can be electrically connected to the contact pad 103' of the second die portion 100c by the first and second PPI structure and the first and second bonding wires 120 and 130.

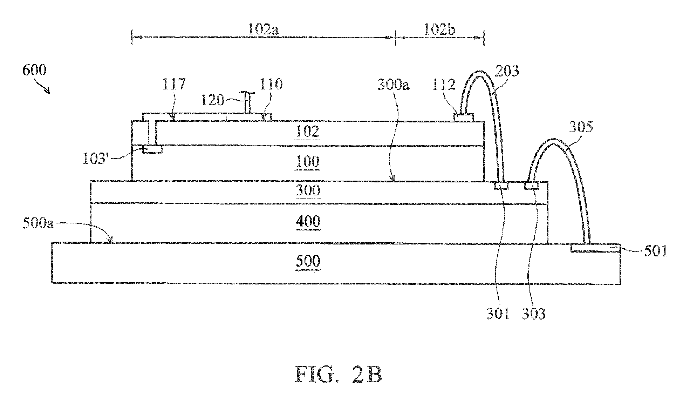

Referring to FIGS. 2A and 2B, FIG. 2A is a top view showing an exemplary embodiment of a semiconductor package 600 having a semiconductor device as shown in FIG. 1A, and FIG. 2B is a side perspective view of an exemplary embodiment of a semiconductor package 600 as shown in FIG. 2A. In the embodiment, the semiconductor package 600 includes a first substrate 300, such as a package substrate, having a device attach surface 300a (as shown in FIG. 2B). A semiconductor die 100 of a semiconductor device as shown in FIG. 1A is attached onto the device attach surface 300a of the first substrate 300. Herein, in order to simplify the diagram, the redistribution lines 115 and 117, as shown in FIG. 1A, are not depicted in FIG. 2A. In one embodiment, the first substrate 300 may include conductive traces (not shown) embedded therein and I/O pads 301 and 303 thereon. In one embodiment, the conductive traces are used for I/O connections of the semiconductor die 100 attached directly onto the first substrate 300. Circuitries of the first die portion 100a and the second die portion 100c of the semiconductor die 100 are electrically connected to the circuitry of the first substrate 300 via conductive paths constructed by fifth pads 112 of the second PPI structure, binding wires 203 and I/O pads 301 of the first substrate 300, and conductive paths constructed by power/ground pads 116 of the second PPI structure, binding wires 203 and I/O pads 301 first substrate 300. Herein, in order to simplify the diagrams, only a conductive path constructed by a fifth pad 112, a binding wire 203 and an I/O pad 301 is depicted, as shown in FIG. 2B. Moreover, only certain conductive paths are depicted, as shown in FIG. 2A.

In the embodiment, the semiconductor package 600 further includes a second semiconductor die 400 disposed under the first substrate 300. In one embodiment, the second semiconductor die 400 may be a memory controller die that is used for controlling the semiconductor device attached on the first substrate 300. In the embodiment, the semiconductor package 600 further includes a second substrate 500 disposed under the second semiconductor die 400, such that the second semiconductor die 400 is interposed between the first substrate 300 and the second substrate 500. In one embodiment, the second substrate 500, such as a print circuit board (PCB), having a device attach surface 500a (as shown in FIG. 2B). The second semiconductor die 400 is attached onto the device attach surface 500a of the second substrate 500. In one embodiment, the second substrate 500 may include conductive traces (not shown) embedded therein and fingers 501 thereon. In one embodiment, the conductive traces are used for I/O connections of the second semiconductor die 400 attached directly onto the second substrate 500. The circuitry of the second semiconductor die 400 is electrically connected to the circuitry of the second substrate 500 via flip chip technology. Moreover, the circuitry of the first substrate 300 is electrically connected to the circuitry of the second substrate 500 via conductive paths constructed by I/O pads 303 of the first substrate 300, bonding wires 305 and fingers 501 of the second substrate 500, such that the semiconductor die 100 is electrically connected to the die 400 through the first substrate 300. Herein, in order to simplify the diagrams, only a conductive path constructed by an I/O pad 303 of the first substrate 300, a bonding wire 305 and a finger 501 of the second substrate 500 is depicted, as shown in FIG. 2B. Moreover, only certain conductive paths are depicted, as shown in FIG. 2A.

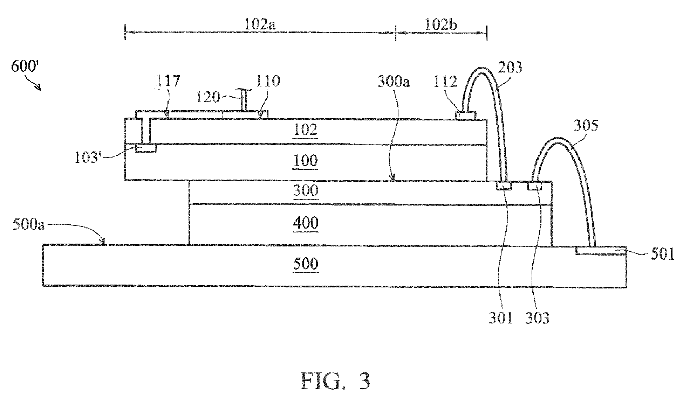

Referring to FIG. 3, which is a side perspective view of an exemplary embodiment of a semiconductor package 600'. Descriptions of elements of the embodiments hereinafter that are the same as or similar to those previously described with reference to FIGS. 2A and 2B may be omitted for brevity. In the embodiment, the semiconductor package 600' is similar to the semiconductor package 600 shown in FIGS. 2A and 2B. In the embodiment, the semiconductor die 100 is misaligned with the first substrate 300 and the second semiconductor die 400, so that a portion of the semiconductor die 100 overhangs both of the first substrate 300 and the second semiconductor die 400. In this case, the second semiconductor die 400 and the first substrate 300 may have a size equal to or greater than that of the die 100. According to the foregoing embodiments, since the semiconductor memory die including two die portions can be provided by dividing an existing wafer, and since the two die portions are electrically connected to each other by die-to-die wire bonding pads and die-to-die bonding wires, the storage capacity of the semiconductor memory package can be increased twofold without increasing the degree of integration of the semiconductor memory die. As a result, fabrication costs and time consumed in development and research environments can be reduced. Moreover, since the circuitry of the semiconductor memory die including two die portions can be electrically connected to the circuitry of the package substrate (i.e., the first substrate) via I/O pads (e.g., the fifth pads) disposed on one of the die portions (e.g., the second die portion) of the semiconductor memory die, the design of the package substrate does not need to change. As a result, cost of designing a new package substrate can be eliminated and the package size can be maintained.

While the invention has been described by way of example and in terms of the preferred embodiments, it is to be understood that the invention is not limited to the disclosed embodiments. On the contrary, it is intended to cover various modifications and similar arrangements (as would be apparent to those skilled in the art). Therefore, the scope of the appended claims should be accorded the broadest interpretation so as to encompass all such modifications and similar arrangements.

## Claims

1. A semiconductor package, comprising:
a semiconductor die having a first die portion, a second die portion, and a scribe line portion between the first and second die portions;
a post-passivation layer on the semiconductor die and having a first region and a second region adjacent thereto;
a first post-passivation interconnect structure, comprising:
a plurality of first pads arranged in a first tier and a plurality of second pads arranged in a second tier, wherein the first and second pads are disposed on the first region of the post-passivation layer corresponding to the first die portion;
a second post-passivation interconnect structure, comprising:
a plurality of third pads arranged in a third tier and a plurality of fourth pads arranged in a fourth tier, wherein the third and fourth pads are disposed on the first region of the post-passivation layer corresponding to the second die portion;
a first bonding wire having two terminals respectively coupled to one of the first pads and one of the fourth pads; and
a second bonding wire having two terminals respectively coupled to one of the second pads and one of the third pads.

2. The semiconductor package as claimed in claim 1, wherein the first, second, third and fourth tiers are parallel to each other.

3. The semiconductor package as claimed in claim 2, wherein the first, second, third and fourth tiers are parallel to an extending direction of the scribe line portion.

4. The semiconductor package as claimed in one of the preceding claims, wherein the first tier is parallel to an edge of the first die portion, and the first tier is closer to the edge the first die portion than the second tier is, and wherein the second tier is closer to the scribe line portion than the first tier is.

5. The semiconductor package as claimed in one of claims 1 to 3, wherein the fourth tier is parallel to an edge of the second die portion, and the fourth tier is closer to the edge the second die portion than the third tier is, and wherein the third tier is closer to the scribe line portion than the fourth tier is.

6. The semiconductor package as claimed in one of the preceding claims, wherein the total number of the first pads is equal to the total number of the fourth pads, and the total number of the second pads is equal to the total number of the third pads.

7. The semiconductor package as claimed in one of the preceding claims, wherein the first bonding wire has a wire bonding height greater than that of the second bonding wire.

8. The semiconductor package as claimed in one of the preceding claims, wherein the second post-passivation interconnect structure further comprises a plurality of fifth pads disposed on the second region of the post-passivation layer corresponding to the second die portion and electrically connected to the third and fourth pads.

9. The semiconductor package as claimed in claim 8, wherein the fifth pads are arranged along a direction perpendicular to the first, second, third and fourth tiers.

10. The semiconductor package as claimed in one of the preceding claims, wherein the semiconductor die is a random access memory die.

11. The semiconductor package as claimed in one of the preceding claims, further comprising:
a first substrate, wherein the semiconductor die is mounted on the first substrate;
a second substrate disposed under the first substrate; and
a second semiconductor die interposed between the first and second substrates.

12. The semiconductor package as claimed in claim 11, wherein the semiconductor memory die is electrically connected to the second semiconductor die through the first substrate.

13. The semiconductor memory package as claimed in claim 11 or 12, wherein the second semiconductor die is electrically connected to the second substrate.

14. The semiconductor memory package as claimed in one of claims 11 to 13, wherein the semiconductor die is misaligned with second semiconductor die, so that a portion of the semiconductor die overhangs the second semiconductor die.

15. The semiconductor memory package as claimed in one of claims 11 to 14, wherein the semiconductor die is misaligned with first substrate, so that a portion of the semiconductor die overhangs the first substrate.
